# EUROPEAN PATENT SPECIFICATION

(11) **EP 3 316 284 B1**
(45) Date of publication and mention of the grant of the patent: **18.05.2022**
(21) Application number: 15892061.1
(22) Date of filing: 30.10.2015
(51) Int. Cl.: H01L 21/77, H01L 27/12, H01L 27/02, H01L 29/417, H01L 29/786, G02F 1/1362

(54) **MANUFACTURING METHOD FOR A MATRIX PANEL OF A DISPLAY DEVICE**
HERSTELLUNGSVERFAHREN EINES MATRIXPANELS FÜR EIN ANZEIGEGERÄT
PROCÉDÉ DE FABRICATION D'UN PANNEAU MATRICIEL POUR UN DISPOSITIF D'AFFICHAGE

(30) Priority: 26.06.2015 CN 201510369478
(43) Date of publication of application: 02.05.2018
(73) Proprietor: BOE Technology Group Co., Ltd., Beijing 100015 (CN); Beijing BOE Display Technology Co., Ltd., Beijing 100176 (CN)
(72) Inventor: ZHANG, Zhichao, Beijing 100176 (CN); KUO , Tsung Chieh, Beijing 100176 (CN); LIU, Zheng, Beijing 100176 (CN); ZHANG, Xiaoxiang, Beijing 100176 (CN); CHEN, Xi, Beijing 100176 (CN); LIU, Mingxuan, Beijing 100176 (CN)
(74) Representative: Klunker IP Patentanwälte PartG mbB
(86) International application number: PCT/CN2015/093387
(87) International publication number: WO 2016/206268

(56) References cited:
- CN-A- 1 612 004
- CN-A- 102 945 846
- CN-A- 104 658 973
- US-A1- 2003 006 463
- US-A1- 2005 186 715
- US-A1- 2009 066 870
- US-A1- 2012 097 426
- US-A1- 2012 168 791
- None

## Description

### TECHNICAL FIELD

The present invention relates a manufacturing method of an array substrate.

### BACKGROUND

In a field of Thin Film Transistor-Liquid Crystal Display (TFT-LCD), a High Advanced Super Dimension Switch (HADS) has characteristics of high aperture ratio and the like and is widely applied in a manufacturing process of a small-sized product. However, a display panel in an HADS mode has an Electro-Static discharge (ESD) problem. Occurrence of ESD is related to an electric potential difference existing between metal wires. In a manufacturing process of an array substrate, because of equipment static electricity, friction static electricity or process discharge or the like, metal blocks or metal wires having been manufactured on -the substrate can gather charges. Because of circuit arrangement, the charges accumulated between the metal blocks or the metal wires are different in polarity and cannot be counteracted, and finally, the electric potential difference is generated between the metal blocks and the metal wires. When the electric potential difference reaches a certain numerical value, ESD can happen between the metal blocks and the metal wires.

US 2009/066870 A1 describes a method for manufacturing an active matrix substrate preventing an increase in the number of production steps while simultaneously preventing electrostatic discharge at a TFT channel.

US 2012/168791 A1 describes a method for preventing electrostatic breakdown during the manufacturing process of the array substrate.

US 2012/097426 A1 describes a shorting line connecting first and second signal lines arranged in parallel with each other in a flat panel display device.

CN 104658973 A describes an array substrate, a manufacturing method of the array substrate and a display device, wherein the array substrate includes a gate drive on array (GOA) region arranged on the substrate.

US 5824235 A discloses a manufacturing method for active matrix LCD involving short circuiting two wiring layers respectively connected to gate and either source or drain.

### SUMMARY

It is an object of the present invention to provide a manufacturing method of an array substrate used for eliminating a problem that ESD happens between metal blocks and metal wires in a period of a manufacturing process of the array substrate.

The object is achieved by the features of the independent claim. Further embodiments are defined in the respective dependent claims.

### BRIEF DESCRIPTION OF THE DRAWINGS

In order to clearly illustrate the technical solution of the embodiments of the disclosure, the drawings of the embodiments will be briefly described in the following; it is obvious that the described drawings are only related to some embodiments of the disclosure and thus are not limitative of the disclosure.
FIG. 1 is a flow diagram of a manufacturing method of an array substrate provided by Example I, not falling within the scope of the present invention;
FIGs. 2a to 2f are plan views of the array substrate formed in Example I
FIGs. 3a to 3f are sectional views corresponding to the plan views illustrated by FIGs. 2a to 2f;
FIGs. 4a to 4f are plan views of an array substrate formed in Example II, not falling within the scope of the present invention;
FIGs. 5a to 5f are sectional views corresponding to the plan views illustrated by FIGs. 4a to 4f;
FIGs. 6a to 6f are plan views of an array substrate formed in Embodiment and
FIGs. 7a to 7f are sectional views corresponding to the plan views illustrated by FIGs. 6a to 6f.

### DETAILED DESCRIPTION

In order to clearly illustrate purposes, technical solutions and advantages of the embodiments of the disclosure, the technical solutions of the embodiments of the present invention will be described in a clearly and fully understandable way in connection with the drawings in the embodiments of the present invention. It is obvious that the described embodiments are just a part but not all of the embodiments of the present invention.

In order to make those skilled in the art better understand the technical solutions of the embodiments of the present invention, an array substrate and a manufacturing method thereof, a display panel and a display device provided by the embodiments of the present invention will be described in detail in connection with the drawings. The embodiments of the present invention only describe an array substrate in an HADS mode, but array substrates in other display modes, such as, a TN mode, a VA mode or an IPS mode are also within the scope of the present invention. In addition, the present invention only describes an HADS 5 Mask process, but an HADS 4 Mask process or other preparation processes related to the present invention arc also within the scope of the present invention.

### Example I

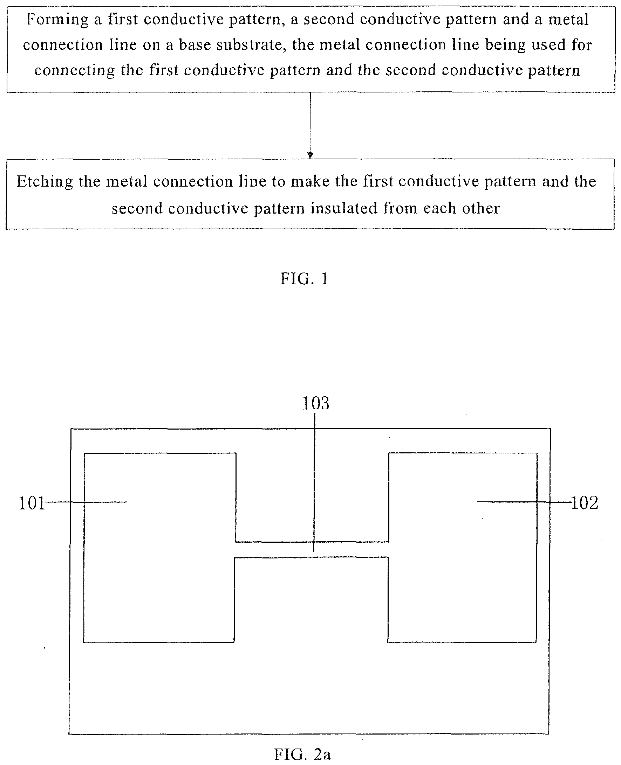

FIG. 1 is a flow diagram of a manufacturing method of an array substrate provided by Example. As illustrated in FIG. 1, the manufacturing method of the array substrate includes:

Step 1001: forming a first conductive pattern, a second conductive pattern and a metal connection line on a base substrate 100, the metal connection line being connected with the first conductive pattern and the second conductive pattern.

In the example, the first conductive pattern includes a first gate electrode metal pattern, the second conductive pattern includes a second gate electrode metal pattern, and the gate electrode metal pattern includes a gate electrode and a gate line.

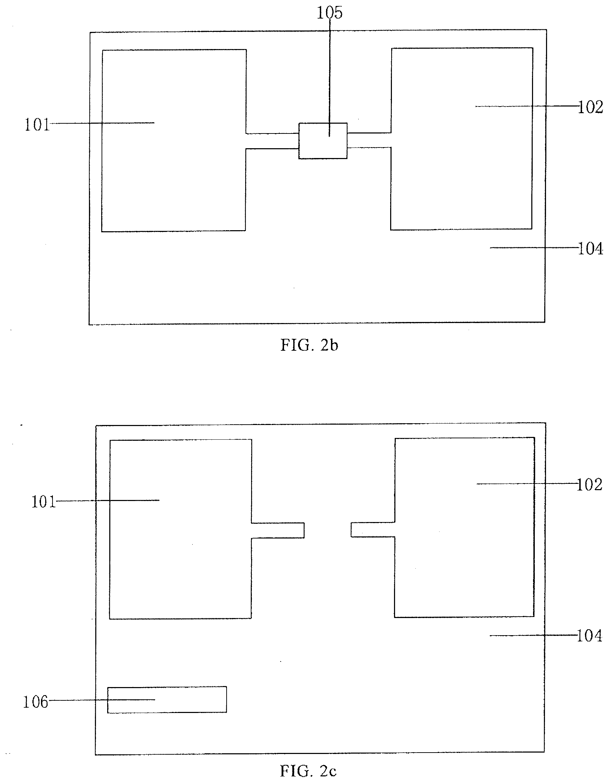

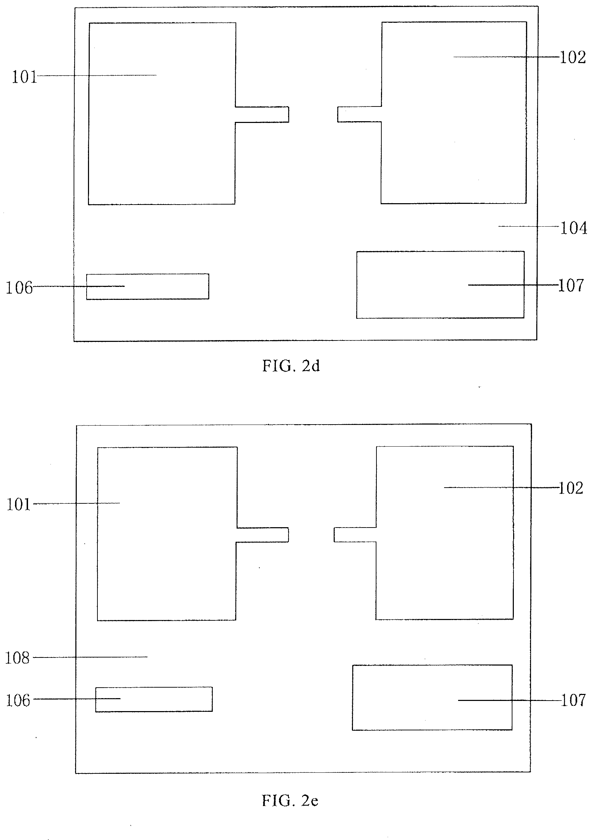

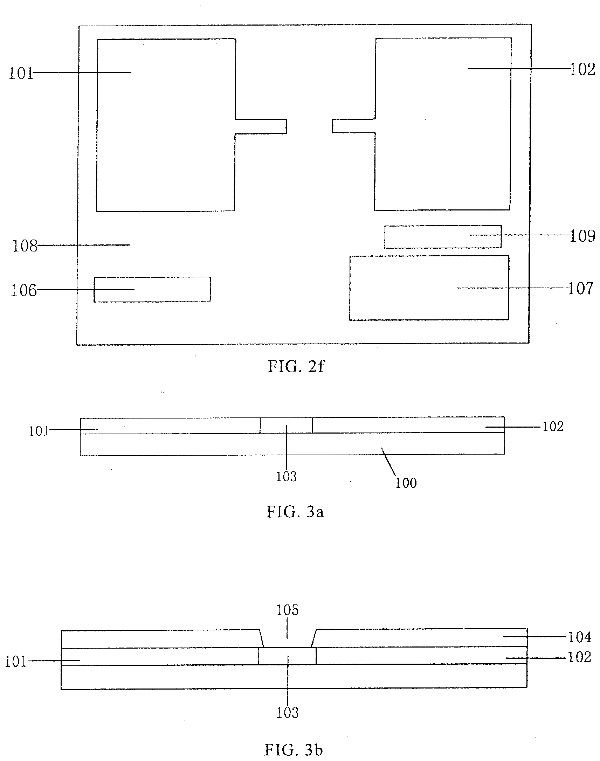

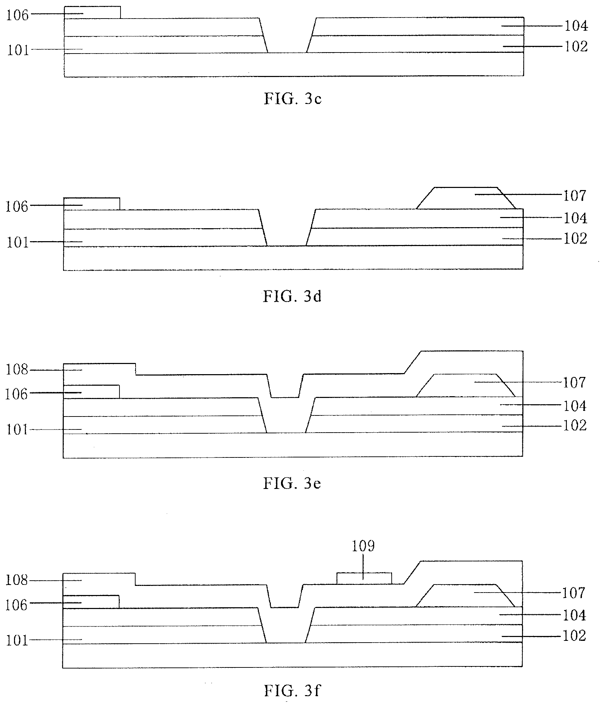

FIGs. 2a to 2f are plan views of the array substrate formed by Example I, and FIGs. 3a to 3f are sectional views corresponding to the plan views illustrated by FIGs. 2a to 2f. As illustrated in FIGs. 2a to 2f and FIGs. 3a to 3f, the first gate electrode metal pattern 101, the second gate electrode metal pattern 102 and the metal connection line 103 are formed on the base substrate 100, and the metal connection line 103 is connected with the first gate electrode metal pattern 101 and the second gate electrode metal pattern 102. The metal connection line 103 provided by the embodiment is connected with the first gate electrode metal pattern 101 and the second gate electrode metal pattern 102 to make a voltage of the first gate electrode metal pattern 101 and a voltage of the second gate electrode metal pattern 102 in a technological process kept to be the same, and therefore an electric potential difference between the first gate electrode metal pattern 101 and the second gate electrode metal pattern 102 can be balanced, an electrostatic discharge phenomenon is avoided, finally, endurance capacity of a product on the electrostatic discharge phenomenon is improved, and a product yield is increased.

In the example, a gate insulating layer and an active layer 104 are formed above the first gate electrode metal pattern 101, the second gate electrode metal pattern 102 and the metal connection line 103. What needs to be explained is that, because the gate insulating layer and the active layer 104 are formed by a single patterning process, in order to facilitate description, the gate insulating layer is not indicated in FIGs. 2a to 2f and FIGS. 3a to 3f. A first via hole 105 corresponding to the meal connection line 103 is opened in the gate insulating layer and the active layer 104, and the metal connection line 103 is exposed through the first via hole 105.

Step 1002: etching the metal connection line to make the first conductive pattern and the second conductive pattern insulated from each other.

In the example, a transparent electrode thin film is formed above the active layer 104, the transparent electrode thin film and the metal connection line 103 are etched to form a first transparent electrode 106. Exemplarily, an etching process comprises wet etching. In the example, the metal connection line 103 is removed through the etching process to make the first gate electrode metal pattern 101 and the second gate electrode metal pattern 102 disconnected, therefore avoiding influence on work performance of the first gate electrode metal pattern 101 and work performance of the second gate electrode metal pattern 102.

In the example, a source electrode metal pattern and a drain electrode metal pattern are formed above the active layer 104, the source electrode metal pattern includes a source electrode and a data line, and the drain electrode metal pattern includes a drain electrode. In the example, the source electrode metal pattern and the drain electrode metal pattern are jointly called a source and drain electrode metal pattern. A passivation layer 108 is formed above a source and drain electrode metal pattern 107 and the first transparent electrode 106, a second transparent electrode 109 is formed above the passivation layer 108. In the first transparent electrode 106 and the second transparent electrode 109, what is connected with the drain electrode is a pixel electrode, and the other is a common electrode.

The manufacturing method of the array substrate provided by the example comprises: forming the first conductive pattern, the second conductive pattern and the metal connection line on the base substrate, the metal connection line being connected with the first conductive pattern and the second conductive pattern; and etching the metal connection line to make the first conductive pattern and the second conductive pattern insulated from each other. The metal connection line provided by the example is connected with the first conductive pattern and the second conductive pattern to make voltage of the first conductive con pattern and voltage of the second conductive pattern in the technological process kept to be the same, and therefore an electric potential difference between the first conductive pattern and the second conductive pattern can be balanced, the electrostatic discharge phenomenon is avoided, finally, the endurance capacity of the product on the electrostatic discharge phenomenon is improved, and the product yield is increased. In addition, in the example, the metal connection line is removed through the etching process to make the first conductive pattern and the second conductive pattern insulated from each other, therefore avoiding influence on work performance of the first conductive pattern and work performance of the second conductive pattern.

### Example II

The example provides a manufacturing method of an array substrate. Referring to FIG. 1, the manufacturing method comprises:

Step 1001: forming a first conductive pattern, a second conductive pattern and a metal connection line on a base substrate, the metal connection line being connected with the first conductive pattern and the second conductive pattern.

In the example, the first conductive pattern includes a first gate electrode metal pattern, the second conductive pattern includes a second gate electrode metal pattern, and the gate electrode metal pattern includes a gate electrode and a gate line.

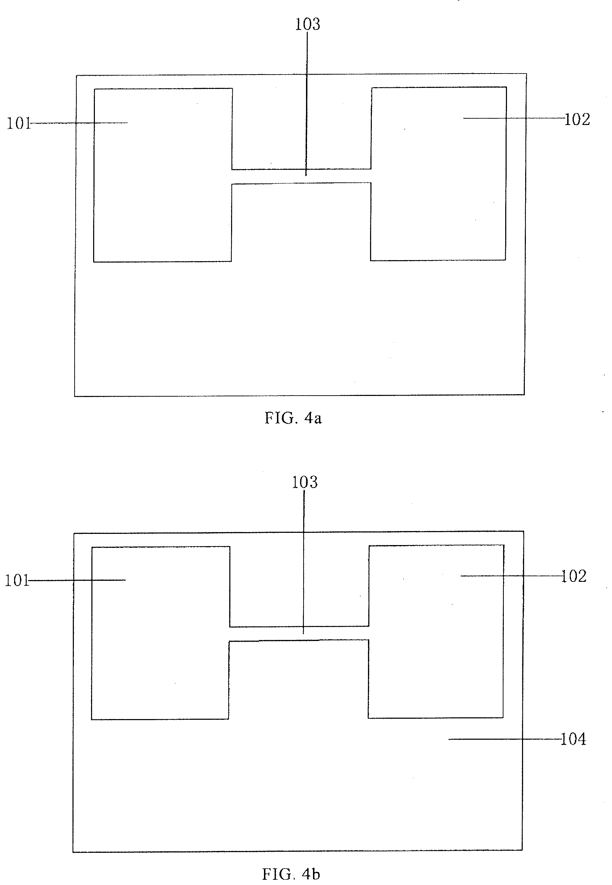

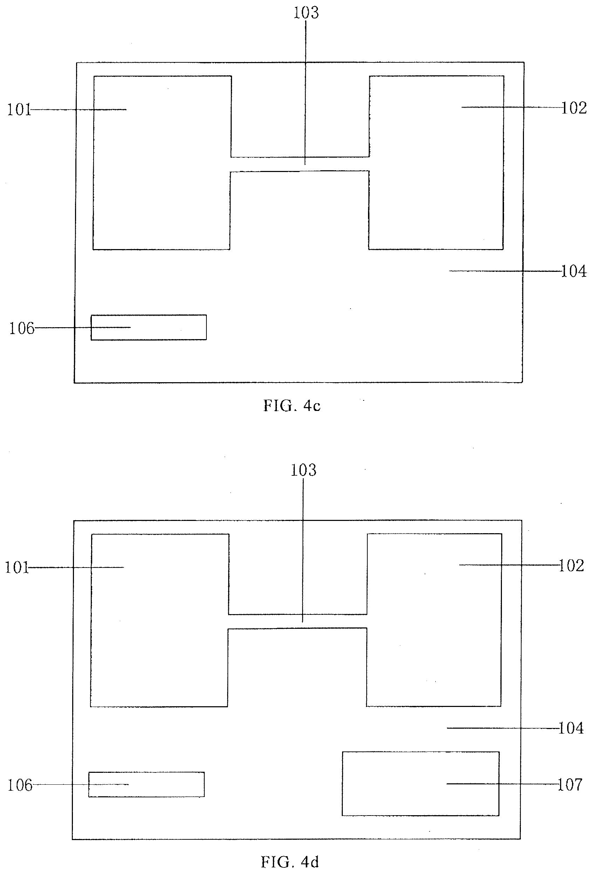

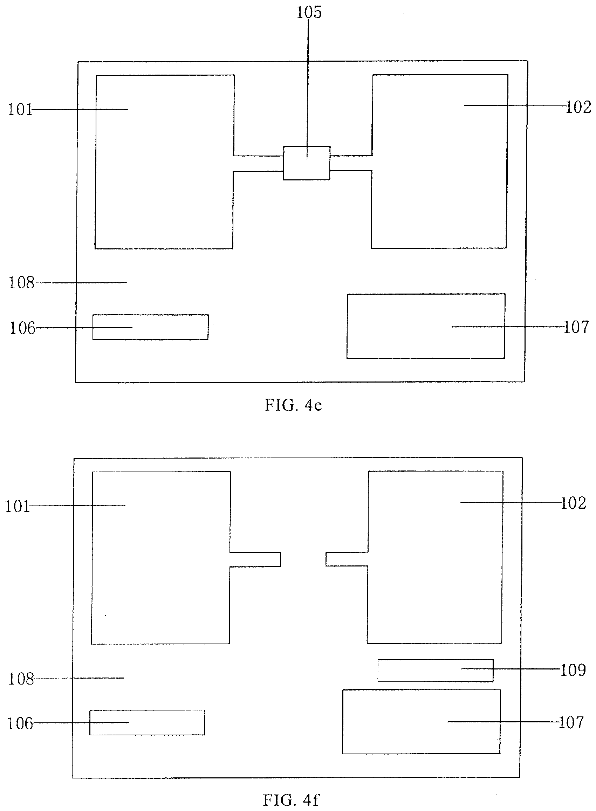

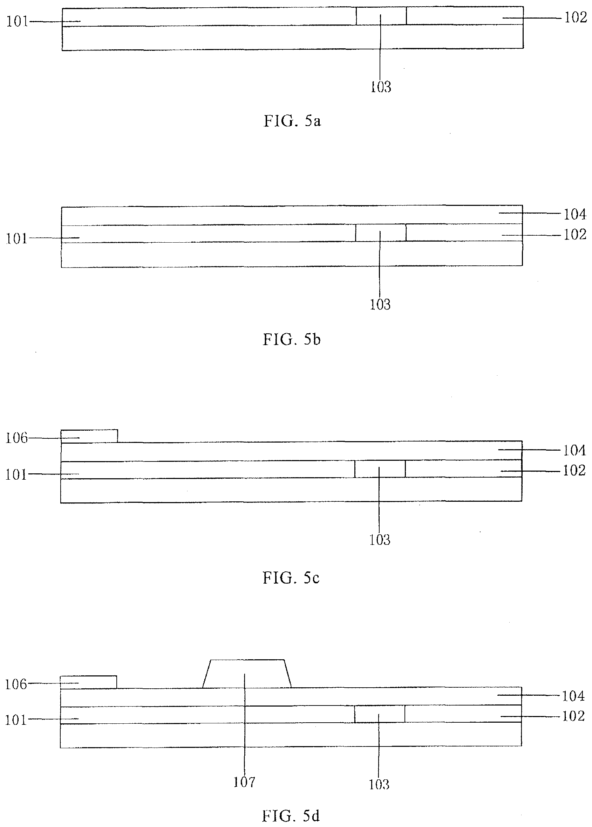

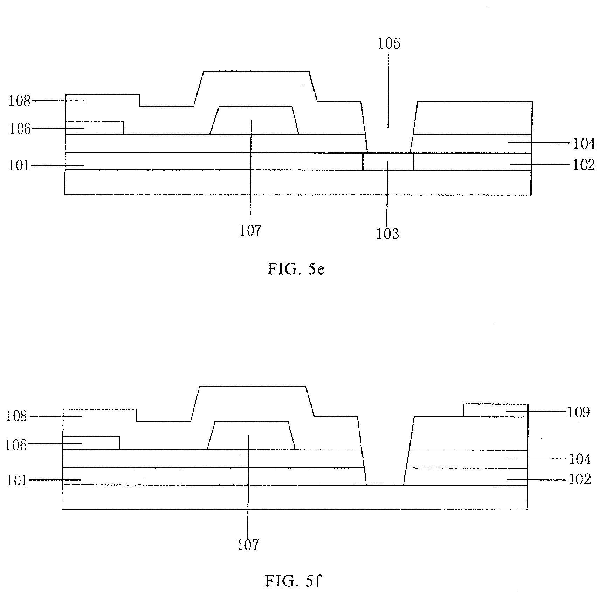

FIGs. 4a to 4f are plan views of the array substrate formed in Example II, and FIGs. 5a to 5f are sectional views corresponding to the plan views illustrated by FIGs. 4a to 4f. As illustrated in FIGs. 4a to 4f and FIGs. 5a to 5f, the first gate electrode metal pattern 101, the second gate electrode metal pattern 102 and the metal connection line 103 are formed on the base substrate, and the metal connection line 103 is connected with the first gate electrode metal pattern 101 and the second gate electrode metal pattern 102. The metal connection line 103 provided by the embodiment is connected with the first gate electrode metal pattern 101 and the second gate electrode metal pattern 102 to make a voltage of the first gate electrode metal pattern 101 and a voltage of the second gate electrode metal pattern 102 in a technological process kept to be the same, and therefore an electric potential difference between the first gate electrode metal pattern 101 and the second gate electrode metal pattern 102 can be balanced, an electrostatic discharge phenomenon is avoided, finally, endurance capacity of a product on the electrostatic discharge phenomenon is improved, and a product yield is increased.

In the example, a gate insulating layer and an active layer 104 are formed above the first gate electrode metal pattern 101, the second gate electrode metal pattern 102 and the metal connection line 103. What needs to be explained is that, because the gate insulating layer and the active layer 104 are formed by a single patterning process, in order to facilitate description, the gate insulating layer is not indicated in FIGs. 4a to 4f and FIGs. 5a to 5f.

Step 1002: etching the metal connection line to make the first conductive pattern and the second conductive pattern insulated from each other.

In the example, a transparent electrode 106 is formed above the active layer 104. A source electrode metal pattern and a drain electrode metal pattern are formed above the active layer 104, the source electrode metal pattern includes a source electrode and a data line, and the drain electrode metal pattern includes a drain electrode. In the embodiment, the source electrode metal pattern and the drain electrode metal pattern are jointly called a source and drain electrode metal pattern. A passivation layer 108 is formed above the source and drain electrode metal pattern 107 and the first transparent electrode 106, a first via hole 105 corresponding to the meal connection line 103 is opened in the passivation layer 108, and the metal connection line 103 is exposed through the first via hole 105.

Exemplarily, a via hole corresponding to the first via hole is further formed in the active layer 4, and therefore the metal connection line 103 can be exposed.

In the example, a transparent electrode thin film is formed above the passivation layer 108, the transparent electrode thin film and the metal connection line 103 are etched to form a second transparent electrode 109. Exemplarily, an etching process comprises wet etching. In the example, the metal connection line 103 is removed through the etching process to make the first gate electrode metal pattern 101 and the second gate electrode metal pattern 102 disconnected, therefore avoiding influence on work performance of the first gate electrode metal pattern 101 and work performance of the second gate electrode metal pattern 102. In addition, in the first transparent electrode 106 and the second transparent electrode 109, what is connected with the drain electrode is a pixel electrode, and the other is a common electrode.

The manufacturing method of the array substrate provided by the example comprises: forming the first conductive pattern, the second conductive pattern and the metal connection line on the base substrate, the metal connection line being connected with the first conductive pattern and the second conductive pattern; and etching the metal connection line to make the first conductive pattern and the second conductive pattern insulated from each other. The metal connection line provided by the embodiment is connected with the first conductive pattern and the second conductive pattern to make a voltage of the first conductive pattern and a voltage of the second conductive pattern in the technological process kept to be the same, and therefore an electric potential difference between the first conductive pattern and the second conductive pattern can be balanced, the electrostatic discharge phenomenon is avoided, finally, the endurance capacity of the product on the electrostatic discharge phenomenon is improved, and the product yield is increased. In addition, in the example, the metal connection line is removed through the etching process to make the first conductive pattern and the second conductive pattern insulated from each other, therefore avoiding influence on work performance of the first conductive pattern and work performance of the second conductive pattern.

### Example III

The example provides a manufacturing method of an array substrate. Referring to FIG. 1, the manufacturing method comprises:

Step 1001: forming a first conductive pattern, a second conductive pattern and a metal connection line on a base substrate, the metal connection line being connected with the first conductive pattern and the second conductive pattern.

In the example, the first conductive pattern includes a source electrode metal pattern, the second conductive pattern includes a drain electrode metal pattern, the source electrode metal pattern includes a source electrode and a data line, and the drain electrode metal pattern includes a drain electrode.

In the example, a gate electrode metal pattern is formed on the base substrate and includes a gate electrode and a gate line. A gate insulating layer and an active layer are formed above the gate electrode metal pattern, and a first transparent electrode is formed above the active layer. The source electrode metal pattern, the drain electrode metal pattern and the metal connection line are formed above the active layer, and the metal connection line is connected with the source electrode metal pattern and the drain electrode metal pattern. The metal connection line provided by the embodiment is connected with the source electrode metal pattern and the drain electrode metal pattern to make a voltage of the source electrode metal pattern and a voltage of the drain electrode metal pattern in a technological process kept to be the same, and therefore an electric potential difference between the source electrode metal pattern and the drain electrode metal pattern can be balanced, an electrostatic discharge phenomenon is avoided, finally, endurance capacity of a product on the electrostatic discharge phenomenon is improved, and a product yield is increased.

Step 1002: etching the metal connection line to make the first conductive pattern and the second conductive pattern insulated from each other.

A passivation layer is formed above the source electrode metal pattern, the drain electrode metal pattern and the first transparent electrode, a first via hole corresponding to the metal connection line is formed in the passivation layer, and the metal connection line is exposed through the first via hole.

In the example, a transparent electrode thin film is formed above the passivation layer, and the transparent electrode thin film and the metal connection line are etched to form a second transparent electrode. In the example, the metal connection line is removed through an etching process to make the source electrode metal pattern and the drain electrode metal pattern disconnected, therefore avoiding influence on work performance of the source electrode metal pattern and work performance of the drain electrode metal pattern. In addition, in the first transparent electrode and the second transparent electrode, what is connected with the drain electrode is a pixel electrode, and the other is a common electrode.

The manufacturing method of the array substrate provided by the example comprises: forming the first conductive pattern, the second conductive pattern and the metal connection line on the base substrate, the metal connection line being connected with the first conductive pattern and the second conductive pattern; and etching the metal connection line to make the first conductive pattern and the second conductive pattern insulated from each other. The metal connection line provided by the example is connected with the first conductive pattern and the second conductive pattern to make a voltage of the first conductive pattern and a voltage of the second conductive pattern in the technological process kept to be the same, and therefore an electric potential difference between the first conductive pattern and the second conductive pattern can be balanced, the electrostatic discharge phenomenon is avoided, finally, the endurance capacity of the product on the electrostatic discharge phenomenon is improved, and the product yield is increased. In addition, in the example, the metal connection line is removed through the etching process to make the first conductive pattern and the second conductive pattern insulated from each other, therefore avoiding influence on work performance of the first conductive pattern and work performance of the second conductive pattern.

### Embodiment I

The embodiment provides a manufacturing method of an array substrate. Referring to FIG. 1, the manufacturing method comprises:
Step 1001: forming a first conductive pattern, a second conductive pattern and a metal connection line on a base substrate, the metal connection line being connected with the first conductive pattern and the second conductive pattern.

In the embodiment, the metal connection line includes a first sub-connection line and a second sub-connection line which are connected with each other, the first sub-connection line is connected with the first conductive pattern, the second sub-connection line is connected with the second conductive pattern, the first conductive pattern includes a gate electrode metal pattern, and the second conductive pattern includes a source electrode metal pattern or a drain electrode metal pattern. The second conductive pattern provided by the embodiment is the source electrode metal pattern, and regarding the content that the second conductive pattern is the drain electrode metal pattern, please refer to Embodiment II. The gate electrode metal pattern includes a gate electrode and a gate line, the source electrode metal pattern includes a source electrode and a data line, and the drain electrode metal pattern includes a drain electrode.

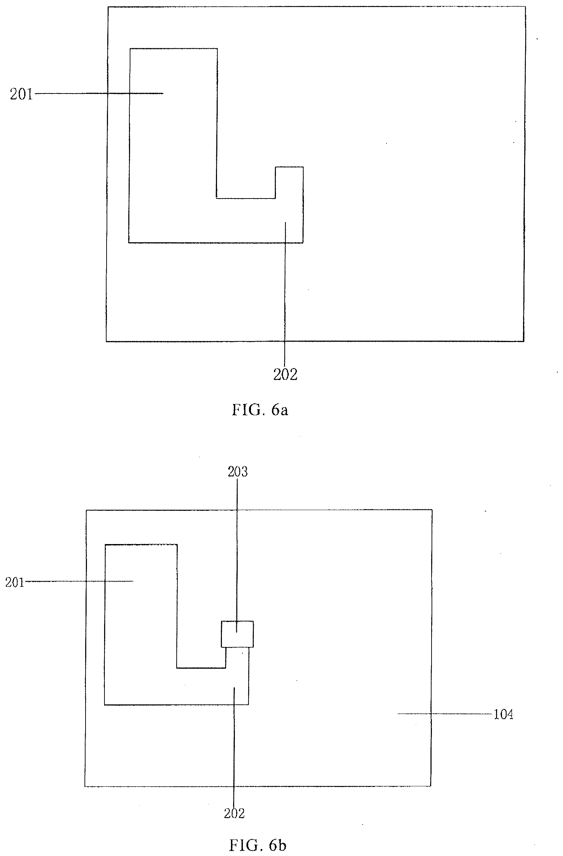

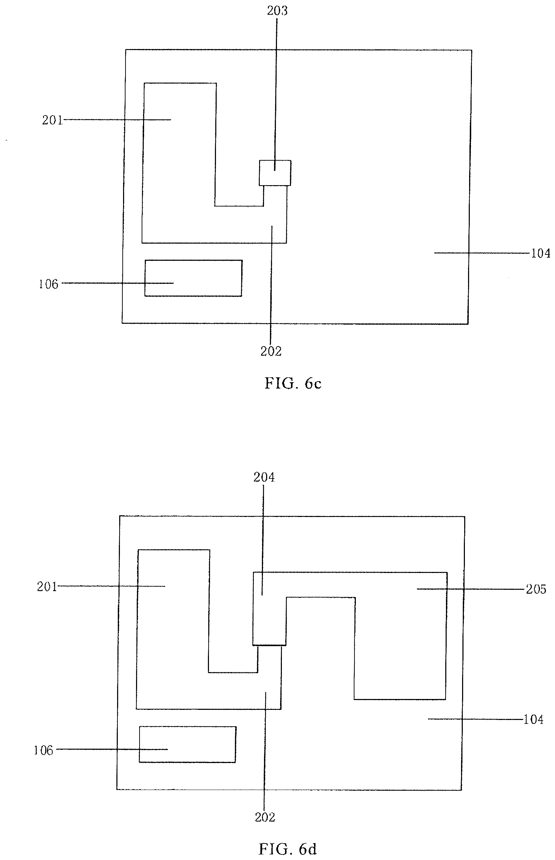

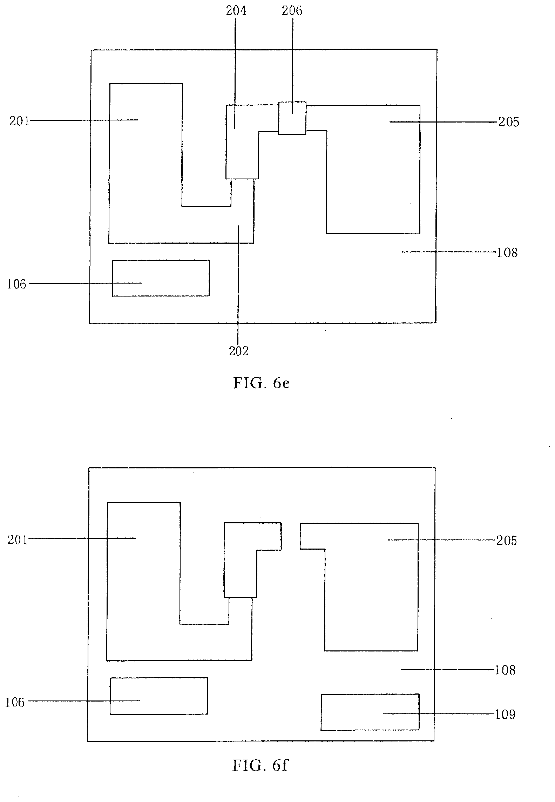

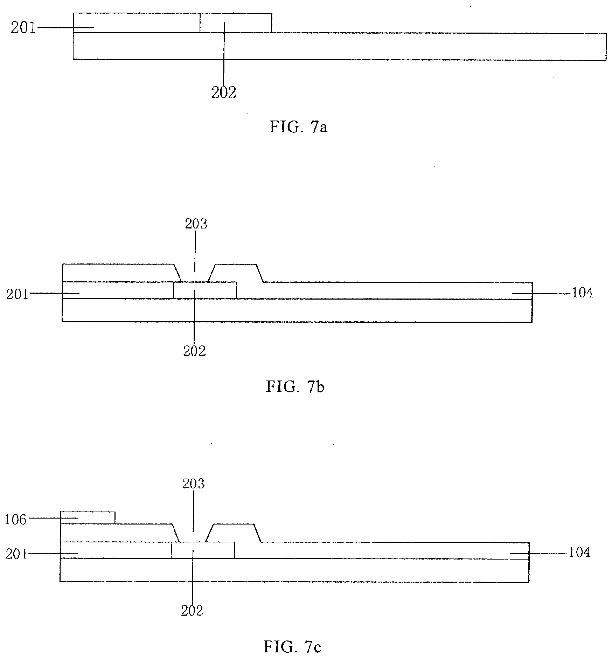

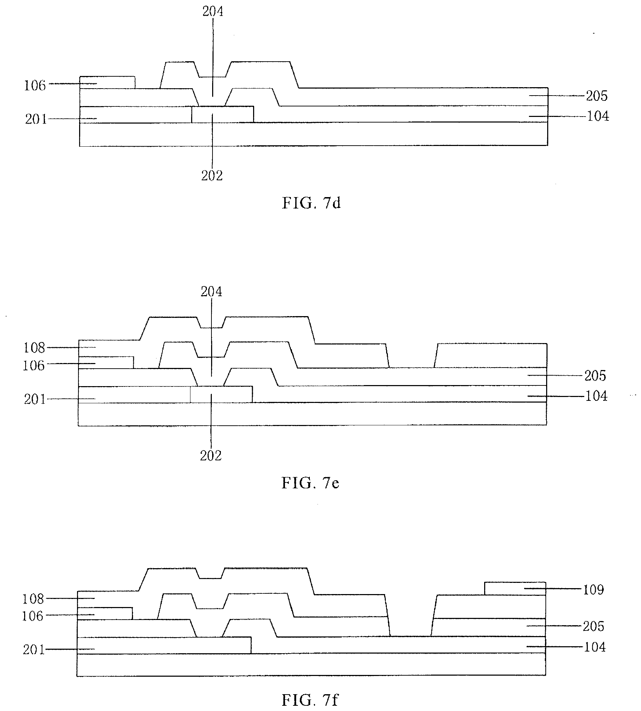

FIGs. 6a to 6f are plan views of the array substrate formed in Embodiment I and FIGs. 7a to 7f are sectional views corresponding to the plan views illustrated by FIGs. 6a to 6f. As illustrated in FIGs. 6a to 6f and FIGs. 7a to 7f, the gate electrode metal pattern 201 and the first sub-connection line 202 are formed on the base substrate, and the first sub-connection line 202 is connected with the gate electrode metal pattern 201. A gate insulating layer and an active layer are formed above the gate electrode metal pattern 201 and the first sub-connection line 202. What needs to be explained is that, because the gate insulating layer and the active layer are formed by a single patterning process, in order to facilitate description, the gate insulating layer is not indicated in FIGs. 6a to 6f and FIGs. 7a to 7f. A second via hole 203 corresponding to the first sub-connection line 202 is opened in the gate insulating layer and the active layer, and the first sub-connection line 202 is exposed through the second via hole 203.

In the embodiment, a first transparent electrode 106 is formed above the active layer 104, the source electrode metal pattern, the drain electrode metal pattern and the second sub-connection wire 204 are formed above the active layer 104. What needs to be explained is that, because the source electrode metal pattern and the drain electrode metal pattern are formed by a single patterning process, in order to facilitate description, the drain electrode metal pattern is not indicated in FIGs. 6a to 6f and FIGs. 7a to 7f. The second sub-connection wire 204 is connected with the source electrode metal pattern 205 and connected with the first sub-connection line 202 through the second via hole 203, the source electrode metal pattern includes the source electrode and the data line, and the drain electrode metal pattern includes the drain electrode. The first sub-connection line 202 and the second sub-connection wire 204 provided by the embodiment are connected with the gate electrode metal pattern 201 and the source electrode metal pattern 205 to make a voltage of the gate electrode metal pattern 201 and a voltage of the source electrode metal pattern 205 in a technological process kept to be the same, and therefore an electric potential difference between the gate electrode metal pattern 201 and the source electrode metal pattern 205 can be balanced, an electrostatic discharge phenomenon is avoided, finally, the endurance capacity of the product on the electrostatic discharge phenomenon is improved, and the product yield is increased.

Step 1002: etching the metal connection line to make the first conductive pattern and the second conductive pattern insulated from each other.

In the embodiment, a passivation layer 108 is formed above the source electrode metal pattern 205 and the first transparent electrode 106, a first via hole 206 corresponding to the second sub-connection line 204 is formed in the passivation layer 108, and the second sub-connection line 204 is exposed through the first via hole 206. Of course, a first via hole 206 corresponding to the first sub-connection line 202 can also be formed in the passivation layer 108.

In the embodiment, a transparent electrode thin film is formed above the passivation layer 108, the transparent electrode thin film and the second sub-connection line 204 are etched to form a second transparent electrode 109. In the embodiment, part or all of the second sub-connection line 204 is removed by an etching process, so that the gate electrode metal pattern 201 and the source electrode metal pattern 205 can be disconnected, therefore avoiding influence on work performance of the gate electrode metal pattern 201 and work performance of the source electrode metal pattern 205. In addition, in the first transparent electrode 106 and the second transparent electrode 109, what is connected with the drain electrode is a pixel electrode, and the other is a common electrode.

The manufacturing method of the array substrate provided by the embodiment comprises: forming the first conductive pattern, the second conductive pattern and the metal connection line on the base substrate, the metal connection line being connected with the first conductive pattern and the second conductive pattern; and etching the metal connection line to make the first conductive pattern and the second conductive pattern insulated from each other. The metal connection line provided by the embodiment is connected with the first conductive pattern and the second conductive pattern to make a voltage of the first conductive pattern and a voltage of the second conductive pattern in the technological process kept to be the same, and therefore an electric potential difference between the first conductive pattern and the second conductive pattern can be balanced, the electrostatic discharge phenomenon is avoided, finally, the endurance capacity of the product on the electrostatic discharge phenomenon is improved, and the product yield is increased. In addition, in the embodiment, the metal connection line is removed through the etching process to make the first conductive pattern and the second conductive pattern insulated from each other, therefore avoiding influence on work performance of the first conductive pattern and work performance of the second conductive pattern.

### Embodiment II

The embodiment provides a manufacturing method of an array substrate. Referring to FIG. 1, the manufacturing method comprises:
Step 1001: forming a first conductive pattern, a second conductive pattern and a metal connection line on a base substrate, the metal connection line being connected with the first conductive pattern and the second conductive pattern.

In the embodiment, the metal connection line includes a first sub-connection line and a second sub-connection line which are connected with each other, the first sub-connection line is connected with the first conductive pattern, the second sub-connection line is connected with the second conductive pattern, the first conductive pattern includes a gate electrode metal pattern, the second conductive pattern includes a drain electrode metal pattern, the gate electrode metal pattern includes a gate electrode and a gate line, a source electrode metal pattern includes a source electrode and a data line, and the drain electrode metal pattern includes a drain electrode.

Step 1002: etching the metal connection line to make the first conductive pattern and the second conductive pattern insulated from each other.

A difference between the manufacturing method provided by the embodiment and the manufacturing method provided by the above Embodiment I lies in that the second sub-connection line in the embodiment is connected with the drain electrode metal pattern, while the second sub-connection line in the above Embodiment I is connected with the source electrode metal pattern; and the rest are completely same. Thus, detailed content can refer to description of the above Embodiment I and will not be repeated herein.

The manufacturing method of the array substrate provided by the embodiment comprises: forming the first conductive pattern, the second conductive pattern and the metal connection line on the base substrate, the metal connection line being connected with the first conductive pattern and the second conductive pattern; and etching the metal connection line to make the first conductive pattern and the second conductive pattern insulated from each other. The metal connection line provided by the embodiment is connected with the first conductive pattern and the second conductive pattern to make a voltage of the first conductive pattern and a voltage of the second conductive pattern in a technological process kept to be the same, and therefore an electric potential difference between the first conductive pattern and the second conductive pattern can be balanced, an electrostatic discharge phenomenon is avoided, finally, endurance capacity of a product on the electrostatic discharge phenomenon is improved, and a product yield is increased. In addition, in the embodiment, the metal connection line is removed through an etching process to make the first conductive pattern and the second conductive pattern insulated from each other, therefore avoiding influence on work performance of the first conductive pattern and work performance of the second conductive pattern.

### Example IV

The example provides an array substrate, which is prepared according to any one of the methods described above, detailed content of a manufacturing method of the array substrate can refer to description of Examples I-III and Embodiments I-II and will not be repeated herein.

In the array substrate provided by the example, the manufacturing method of the array substrate comprises: forming the first conductive pattern, the second conductive pattern and the metal connection line on the base substrate, the metal connection line being connected with the first conductive pattern and the second conductive pattern; and etching the metal connection line to make the first conductive pattern and the second conductive pattern insulated from each other. The metal connection line provided by the example is connected with the first conductive pattern and the second conductive pattern to make a voltage of the first conductive pattern and a voltage of the second conductive pattern in a technological process kept to be the same, and therefore an electric potential difference between the first conductive pattern and the second conductive pattern can be balanced, an electrostatic discharge phenomenon is avoided, finally, endurance capacity of a product on the electrostatic discharge phenomenon is improved, and a product yield is increased. In addition, in the example, the metal connection line is removed through an etching process to make the first conductive pattern and the second conductive pattern insulated from each other, therefore avoiding influence on work performance of the first conductive pattern and work performance of the second conductive pattern.

### Example V

The example provides a display substrate, comprising: the array substrate provided by the above Example IV and a substrate opposite to the array substrate, and detailed content can refer to description of the above Example IV and will not be repeated herein.

In the display panel provided with the example, a manufacturing method of the array substrate comprises: forming a first conductive pattern, a second conductive pattern and a metal connection line on a base substrate, the metal connection line being connected with the first conductive pattern and the second conductive pattern; and etching the metal connection line to make the first conductive pattern and the second conductive pattern insulated from each other. The metal connection line provided by the example is connected with the first conductive pattern and the second conductive pattern to make a voltage of the first conductive pattern and a voltage of the second conductive pattern in a technological process kept to be the same, and therefore an electric potential difference between the first conductive pattern and the second conductive pattern can be balanced, an electrostatic discharge phenomenon is avoided, finally, endurance capacity of a product on the electrostatic discharge phenomenon is improved, and a product yield is increased. In addition, in the example, the metal connection line is removed through an etching process to make the first conductive pattern and the second conductive pattern insulated from each other, therefore avoiding influence on work performance of the first conductive pattern and work performance of the second conductive pattern.

### Example VI

The embodiment provides a display device, comprising the display panel provided by the above Example V, and detailed content can refer to description of the above Example V and will not be repeated herein.

In the display device provided by the example, a manufacturing method of an array substrate comprises: forming a first conductive pattern, a second conductive pattern and a metal connection line on a base substrate, the metal connection line being connected with the first conductive pattern and the second conductive pattern; and etching the metal connection line to make the first conductive pattern and the second conductive pattern insulated from each other. The metal connection line provided by the example is connected with the first conductive pattern and the second conductive pattern to make a voltage of the first conductive pattern and a voltage of the second conductive pattern in a technological process kept to be the same, and therefore an electric potential difference between the first conductive pattern and the second conductive pattern can be balanced, an electrostatic discharge phenomenon is avoided, finally, endurance capacity of a product on the electrostatic discharge phenomenon is improved, and a product yield is increased. In addition, in the example, the metal connection line is removed through an etching process to make the first conductive pattern and the second conductive pattern insulated from each other, therefore avoiding influence on work performance of the first conductive pattern and work performance of the second conductive pattern.

In the array substrate and the manufacturing method of thereof, the display panel and the display device provided by the examples, the manufacturing method comprises: forming a first conductive pattern, a second conductive pattern and a metal connection line on a base substrate, the metal connection line being connected with the first conductive pattern and the second conductive pattern; and etching the metal connection line to make the first conductive pattern and the second conductive pattern insulated from each other. The metal connection line provided by the example is connected with the first conductive pattern and the second conductive pattern to make a voltage of the first conductive pattern and a voltage of the second conductive pattern in a technological process kept to be the same, and therefore an electric potential difference between the first conductive pattern and the second conductive pattern can be balanced, an electrostatic discharge phenomenon is avoided, finally, endurance capacity of a product on the electrostatic discharge phenomenon is improved, and a product yield is increased. In addition, in the example, the metal connection line is removed through an etching process to make the first conductive pattern and the second conductive pattern insulated from each other, therefore avoiding influence on work performance of the first conductive pattern and work performance of the second conductive pattern.

## Claims

1. A manufacturing method of an array substrate, comprising:
forming a first conductive pattern (201), a second conductive pattern (205) and a metal connection line (202, 204) on a base substrate (100), the metal connection line (202, 204) being connected with the first conductive pattern (201) and the second conductive pattern (205);
etching the metal connection line (202, 204) to make the first conductive pattern (201) and the second conductive pattern (205) insulated from each other;
wherein, the metal connection line (202, 204) includes a first sub-connection line (202) and a second sub-connection line (204) which are connected with each other, the first sub-connection line (202) is connected with the first conductive pattern (201), and the second sub-connection line (204) is connected with the second conductive pattern (205);
wherein, the first conductive pattern (201) includes a gate electrode metal pattern, the second conductive pattern (205) includes a source electrode metal pattern or a drain electrode metal pattern, the gate electrode metal pattern includes a gate electrode and a gate line, the source electrode metal pattern includes a source electrode and a data line, and the drain electrode metal pattern includes a drain electrode;
wherein, forming the first conductive pattern (201), the second conductive pattern (205) and the metal connection line (202, 204) on the base substrate (100) includes:
forming the gate electrode metal pattern and the first sub-connection line (202) on the base substrate, the first sub-connection line (202) being connected with the gate electrode metal pattern;
forming a gate insulating layer and an active layer above the gate electrode metal pattern and the first sub-connection line (202), and forming a second via hole (203) corresponding to the first sub-connection line (202) in the gate insulating layer and the active layer;
forming a first transparent electrode (106) above the gate insulating layer and the active layer (104);
forming the source electrode metal pattern, the drain electrode metal pattern and the second sub-connection line (204) above the gate insulating layer and the active layer, the second sub-connection line (204) being connected with the source electrode metal pattern or the drain electrode metal pattern, and the second sub-connection line being connected with the first sub-connection line through the second via hole (203);
before etching the metal connection line (202, 204) to make the first conductive pattern (201) and the second conductive pattern (205) insulated from each other and after forming the first conductive pattern (201), the second conductive pattern (205) and the metal connection line (202, 204) on the base substrate (100), the method includes:
forming a passivation layer above the source electrode metal pattern, the drain electrode metal pattern and the second sub-connection line, and forming a first via hole (206) corresponding to the first sub-connection line (202) or the second sub-connection line (204) in the passivation layer to expose the first sub-connection line (202) or the second sub-connection line (204);
etching the metal connection line (202, 204) to make the first conductive pattern (201) and the second conductive pattern (205) insulated from each other includes:
forming a transparent electrode thin film above the passivation layer;
etching the transparent electrode thin film and the first sub-connection line (202) or the second sub-connection line (204) to form a second transparent electrode (109) and to make the first conductive pattern (201) insulated from the second conductive pattern (205);
wherein both the first transparent electrode (106) and the source electrode metal pattern are in contact with the active layer (104), respectively.

2. The manufacturing method of the array substrate according to claim 1, wherein the second sub-connection line (204) is in contact with the active layer (104).

3. The manufacturing method of the array substrate according to any one of claims 1 to 2, wherein the gate insulating layer and the active layer (104) are formed by a single patterning process.

4. The manufacturing method of the array substrate according to any one of claims 1 to 3, wherein the first sub-connection line (202) and the second sub-connection line (204) are located in different layers.

5. The manufacturing method of the array substrate according to any one of claims 1 to 4, wherein the first sub-connection line (202) and the second sub-connection line (204) are overlapped with each other in a direction perpendicular to the base substrate (100).

6. The manufacturing method of the array substrate according to any one of claims 1 to 5, wherein the first transparent electrode (106) or the second transparent electrode (109) is connected with the drain electrode, and is a pixel electrode, and the other is a common electrode.

7. The manufacturing method of the array substrate according to any one of claims 1 to 6, wherein the source electrode metal pattern and the drain electrode metal pattern are formed by a single patterning process.

8. The manufacturing method of the array substrate according to any one of claims 1 to 7, wherein the etching includes wet etching.

## Patentansprüche

1. Herstellungsverfahren für ein Array-Substrat, mit:
Bilden einer ersten leitenden Struktur (201), einer zweiten leitenden Struktur (205) und einer Metallverbindungsleitung (202, 204) auf einem Basissubstrat (100), wobei die Metallverbindungsleitung (202, 204) mit der ersten leitenden Struktur (201) und der zweiten leitenden Struktur (205) verbunden ist;
Ätzen der Metallverbindungsleitung (202, 204), um die erste leitende Struktur (201) und die zweite leitende Struktur (205) voneinander zu isolieren;
wobei die Metallverbindungsleitung (202, 204) eine erste Unterverbindungsleitung (202) und eine zweite Unterverbindungsleitung (204) aufweist, die miteinander verbunden sind, wobei die erste Unterverbindungsleitung (202) mit der ersten leitenden Struktur (201) verbunden ist, und die zweite Unterverbindungsleitung (204) mit der zweiten leitenden Struktur (205) verbunden ist;
wobei die erste leitende Struktur (201) ein Gate-Elektroden-Metallstruktur aufweist, die zweite leitende Struktur (205) eine Source-Elektroden-Metallstruktur oder eine Drain-Elektroden-Metallstruktur aufweist, die Gate-Elektroden-Metallstruktur eine Gate-Elektrode und eine Gate-Leitung aufweist, die Source-Elektroden-Metallstruktur eine Source-Elektrode und eine Datenleitung aufweist, und die Drain-Elektroden-Metallstruktur eine Drain-Elektrode aufweist;
wobei das Bilden der ersten leitenden Struktur (201), der zweiten leitenden Struktur (205) und der Metallverbindungsleitung (202, 204) auf dem Basissubstrat (100) aufweist:
Bilden der Gate-Elektroden-Metallstruktur und der ersten Unterverbindungsleitung (202) auf dem Basissubstrat, wobei die erste Unterverbindungsleitung (202) mit der Gate-Elektroden-Metallstruktur verbunden ist;
Bilden einer Gate-Isolierschicht und einer aktiven Schicht über der Gate-Elektroden-Metallstruktur und der ersten Unterverbindungsleitung (202), und Bilden eines zweiten Durchgangslochs (203) zugehörig zu der ersten Unterverbindungsleitung (202) in der Gate-Isolierschicht und der aktiven Schicht;
Bilden einer ersten transparenten Elektrode (106) über der Gate-Isolierschicht und der aktiven Schicht (104);
Bilden der Gate-Elektroden-Metallstruktur, der Drain-Elektroden-Metallstruktur und der zweiten Unterverbindungsleitung (204) über der Gate-Isolierschicht und der aktiven Schicht, wobei die zweite Unterverbindungsleitung (204) mit der Gate-Elektroden-Metallstruktur oder der Drain-Elektroden-Metallstruktur verbunden ist, und die zweite Unterverbindungsleitung mit der ersten Unterverbindungsleitung durch das zweite Durchgangsloch (203) verbunden ist;
wobei, vor dem Ätzen der Metallverbindungsleitung (202, 204), um die erste leitende Struktur (201) und die zweite leitende Struktur (205) voneinander zu isolieren, und nach dem Bilden der ersten leitenden Struktur (201), der zweiten leitenden Struktur (205) und der Metallverbindungsleitung (202, 204) auf dem Basissubstrat (100), das Verfahren aufweist:
Bilden einer Passivierungsschicht über der Source-Elektroden-Metallstruktur, der Drain-Elektroden-Metallstruktur und der zweiten Unterverbindungsleitung, und Bilden eines ersten Durchgangslochs (206) zugehörig zu der ersten Unterverbindungsleitung (202) oder der zweiten Unterverbindungsleitung (204) in der Passivierungsschicht, um die erste Unterverbindungsleitung (202) oder die zweite Unterverbindungsleitung (204) freizulegen;
wobei Ätzen der Metallverbindungsleitung (202, 204), um die erste leitende Struktur (201) und die zweite leitende Struktur (205) voneinander zu isolieren, aufweist:
Bilden einer transparenten Dünnschicht für die Elektrode über der Passivierungsschicht;
Ätzen der transparenten Elektroden-Dünnschicht und der ersten Unterverbindungsleitung (202) oder der zweiten Unterverbindungsleitung (204), um eine zweite transparente Elektrode (109) zu bilden und um die erste leitende Struktur (201) von der zweiten leitenden Struktur (205) zu isolieren;
wobei sowohl die erste transparente Elektrode (106) als auch die Source-Elektroden-Metallstruktur jeweils in Kontakt mit der aktiven Schicht (104) stehen.

2. Herstellungsverfahren für das Array-Substrat nach Anspruch 1, wobei die zweite Unterverbindungsleitung (204) in Kontakt mit der aktiven Schicht (104) steht.

3. Herstellungsverfahren für das Array-Substrat nach einem der Ansprüche 1 bis 2, wobei die Gate-Isolierschicht und die aktive Schicht (104) durch einen einzigen Strukturierungsprozess gebildet werden.

4. Herstellungsverfahren für das Array-Substrat nach einem der Ansprüche 1 bis 3, wobei die erste Unterverbindungsleitung (202) und die zweite Unterverbindungsleitung (204) in verschiedenen Schichten angeordnet sind.

5. Herstellungsverfahren für das Array-Substrat nach einem der Ansprüche 1 bis 4, wobei die erste Unterverbindungsleitung (202) und die zweite Unterverbindungsleitung (204) einander in einer Richtung senkrecht zum Basissubstrat (100) überlappen.

6. Herstellungsverfahren für das Array-Substrat nach einem der Ansprüche 1 bis 5, wobei die erste transparente Elektrode (106) oder die zweite transparente Elektrode (109) mit der Drain-Elektrode verbunden ist und eine Pixel-Elektrode ist, und die andere eine gemeinsame Elektrode ist.

7. Herstellungsverfahren für das Array-Substrat nach einem der Ansprüche 1 bis 6, wobei die Source-Elektroden-Metallstruktur und die Drain-Elektroden-Metallstruktur durch einen einzigen Strukturierungsprozess gebildet werden.

8. Herstellungsverfahren für das Array-Substrat nach einem der Ansprüche 1 bis 7, wobei das Ätzen ein Nassätzen aufweist.

## Revendications

1. Procédé de fabrication d'un substrat de réseau, comprenant :
la formation d'un premier motif conducteur (201), d'un second motif conducteur (205) et d'une ligne de connexion en métal (202, 204) sur un substrat de base (100), la ligne de connexion en métal (202, 204) étant connectée au premier motif conducteur (201) et au second motif conducteur (205) ; et
la gravure de la ligne de connexion en métal (202, 204) pour faire en sorte que le premier motif conducteur (201) et le second motif conducteur (205) soient isolés l'un de l'autre ;
dans lequel la ligne de connexion en métal (202, 204) inclut une première ligne de sous-connexion (202) et une seconde ligne de sous-connexion (204) qui sont connectées l'une à l'autre, la première ligne de sous-connexion (202) est connectée au premier motif conducteur (201) et la seconde ligne de sous-connexion (204) est connectée au second motif conducteur (205) ;
dans lequel le premier motif conducteur (201) inclut un motif en métal d'électrode de grille, le second motif conducteur (205) inclut un motif en métal d'électrode de source ou un motif en métal d'électrode de drain, le motif en métal d'électrode de grille inclut une électrode de grille et une ligne de grille, le motif en métal d'électrode de source inclut une électrode de source et une ligne de données et le motif en métal d'électrode de drain inclut une électrode de drain ; et
dans lequel la formation du premier motif conducteur (201), du second motif conducteur (205) et de la ligne de connexion en métal (202, 204) sur le substrat de base (100) inclut :
la formation du motif en métal d'électrode de grille et de la première ligne de sous-connexion (202) sur le substrat de base, la première ligne de sous-connexion (202) étant connectée au motif en métal d'électrode de grille ;
la formation d'une couche d'isolation de grille et d'une couche active au-dessus du motif en métal d'électrode de grille et de la première ligne de sous-connexion (202) et la formation d'un second trou de via (203) qui correspond à la première ligne de sous-connexion (202) dans la couche d'isolation de grille et la couche active ;
la formation d'une première électrode transparente (106) au-dessus de la couche d'isolation de grille et de la couche active (104) ; et
la formation du motif en métal d'électrode de source, du motif en métal d'électrode de drain et de la seconde ligne de sous-connexion (204) au-dessus de la couche d'isolation de grille et de la couche active, la seconde ligne de sous-connexion (204) étant connectée au motif en métal d'électrode de source ou au motif en métal d'électrode de drain et la seconde ligne de sous-connexion étant connectée à la première ligne de sous-connexion au travers du second trou de via (203) ;
avant la gravure de la ligne de connexion en métal (202, 204) pour faire en sorte que le premier motif conducteur (201) et le second motif conducteur (205) soient isolés l'un de l'autre et après la formation du premier motif conducteur (201), du second motif conducteur (205) et de la ligne de connexion en métal (202, 204) sur le substrat de base (100), le procédé inclut :
la formation d'une couche de passivation au-dessus du motif en métal d'électrode de source, du motif en métal d'électrode de drain et de la seconde ligne de sous-connexion et la formation d'un premier trou de via (206) qui correspond à la première ligne de sous-connexion (202) ou à la seconde ligne de sous-connexion (204) dans la couche de passivation pour exposer la première ligne de sous-connexion (202) ou la seconde ligne de sous-connexion (204) ;
la gravure de la ligne de connexion en métal (202, 204) pour faire en sorte que le premier motif conducteur (201) et le second motif conducteur (205) soient isolés l'un de l'autre inclut :
la formation d'un film mince d'électrode transparente au-dessus de la couche de passivation ; et
la gravure du film mince d'électrode transparente et de la première ligne de sous-connexion (202) ou de la seconde ligne de sous-connexion (204) pour former une seconde électrode transparente (109) et pour faire en sorte que le premier motif conducteur (201) soit isolé du second motif conducteur (205) ;
dans lequel la première électrode transparente (106) et le motif en métal d'électrode de source sont respectivement en contact avec la couche active (104).

2. Procédé de fabrication du substrat de réseau selon la revendication 1, dans lequel la seconde ligne de sous-connexion (204) est en contact avec la couche active (104).

3. Procédé de fabrication du substrat de réseau selon l'une quelconque des revendications 1 et 2, dans lequel la couche d'isolation de grille et la couche active (104) sont formées au moyen d'un unique processus de formation de motif(s).

4. Procédé de fabrication du substrat de réseau selon l'une quelconque des revendications 1 à 3, dans lequel la première ligne de sous-connexion (202) et la seconde ligne de sous-connexion (204) sont localisées dans des couches différentes.

5. Procédé de fabrication du substrat de réseau selon l'une quelconque des revendications 1 à 4, dans lequel la première ligne de sous-connexion (202) et la seconde ligne de sous-connexion (204) sont en chevauchement l'une sur l'autre dans une direction qui est perpendiculaire au substrat de base (100).

6. Procédé de fabrication du substrat de réseau selon l'une quelconque des revendications 1 à 5, dans lequel la première électrode transparente (106) ou la seconde électrode transparente (109) est connectée à l'électrode de drain et est une électrode de pixel et l'autre électrode est une électrode commune.

7. Procédé de fabrication du substrat de réseau selon l'une quelconque des revendications 1 à 6, dans lequel le motif en métal d'électrode de source et le motif en métal d'électrode de drain sont formés au moyen d'un unique processus de formation de motif(s).

8. Procédé de fabrication du substrat de réseau selon l'une quelconque des revendications 1 à 7, dans lequel la gravure inclut une gravure par voie humide.
